Europäisches Patentamt

European Patent Office

Office européen des brevets

(19)

(11) **EP 1 249 940 B1**

(12) **FASCICULE DE BREVET EUROPEEN**

(45) Date de publication et mention
de la délivrance du brevet:
**17.05.2006 Bulletin 2006/20**

(51) Int Cl.:
***H03M 13/37*** *(2006.01)* ***H03M 13/29*** *(2006.01)*

(21) Numéro de dépôt: **02290594.7**

(22) Date de dépôt: **08.03.2002**

(54) **Procédé d'optimisation, sous contrainte de ressources, de la taille de blocs de données codées**

Verfahren zur Optimisierung, unter Betriebsmittelzwangsbedingungen, der Grösse von kodierten Datenblöcken

Method for optimizing, under resource constraints, of the size of coded data blocs

(84) Etats contractants désignés:
**AT BE CH CY DE DK ES FI FR GB GR IE IT LI LU MC NL PT SE TR**

(30) Priorité: **19.03.2001 FR 0103789**

(43) Date de publication de la demande:
**16.10.2002 Bulletin 2002/42**

(73) Titulaire: **Mitsubishi Electric Information Technology Centre Europe B.V.**
**1119 NS Schiphol Rijk (NL)**

(72) Inventeur: **Gueguen, Arnaud,**
**Mitsubishi Electricité,**
**Immeuble**
**35700 Rennes (FR)**

(74) Mandataire: **Maillet, Alain**
**SCP Le Guen & Maillet,**
**5, Place Newquay,**
**B.P. 70250**
**35802 Dinard Cedex (FR)**

(56) Documents cités:
**EP-A- 0 917 294** **WO-A-99/11009**
**WO-A-99/50963** **US-A- 5 721 745**

**Description**

La présente invention concerne un procédé d'optimisation de taille de bloc de données codées destiné à être soumis à un décodage itératif, tel que celui mis en oeuvre dans un turbo-décodeur ou un turbo-égaliseur. Elle s'applique en particulier aux systèmes de télécommunication dits de troisième génération.

Le concept de turbo-code a été introduit par C. Berrou, A. Glavieux , P. Thitimajshima dans leur article "Near Shannon Limit Error - Correcting Coding and Decoding: Turbo-codes", ICC-1993, Conference Proceedings, pp. 1064-1070 et a fait, comme on le sait, l'objet de nombreux développements.

On rappelle que le turbo-codage résulte de la concaténation codes élémentaires séparées par des étapes d'entrelacement. Les codes élémentaires peuvent être de différents types : codes récursifs systématiques (notés RSC) pour les turbo-codes convolutifs ou codes en blocs (RS, BCH) pour les turbo-codes en bloc. Ces derniers ont été décrits par « R. Pyndiah, P. Combelles et P. Adde dans un article intitulé « A very low complexity block turbo decoder for product codes » publié dans Proc. of IEEE Globecom, pp. 101-105, 1996. Différents types de concaténation ont été envisagés comme la concaténation parallèle, dans laquelle la même information est codée séparément par chaque codeur après avoir été entrelacée et la concaténation série dans laquelle la sortie de chaque codeur est entrelacée avant d'être codée par le codeur suivant. Pour une description détaillée, on pourra se référer pour la concaténation parallèle à l'article de Berrou et al. précité et pour la concaténation série à l'article de S. Benedetto, G. Montorsi, D. Divsalar et F. Pollara, "Serial concatenation of interleaved codes : Performance analysis, design and iterative decoding", JPL TDA Progr. Rep., Vol. 42-126, Aug. 1996.

Le décodage d'un turbo-code est classiquement effectué au moyen d'un processus itératif encore appelé turbo-décodage, constitué d'une suite d'opérations de décodage élémentaires, chaque opération de décodage élémentaire recevant des valeurs d'entrée pondérées et fournissant des valeurs de sortie pondérées, relatives respectivement à l'entrée et (pour un turbo-code série) à la sortie de l'opération de codage élémentaire correspondante. Les valeurs d'entrée et de sortie pondérées traduisent les probabilités des symboles binaires ou M-aires en entrée et (pour un turbo-code série) en sortie du codeur élémentaire correspondant. Des opérations de désentrelacement et d'entrelacement interviennent en fonction des opérations d'entrelacement effectuées au niveau du codage et permettent à chaque opération de décodage élémentaire de prendre en compte les données dans le même ordre que celui en entrée de l'opération de codage correspondante.

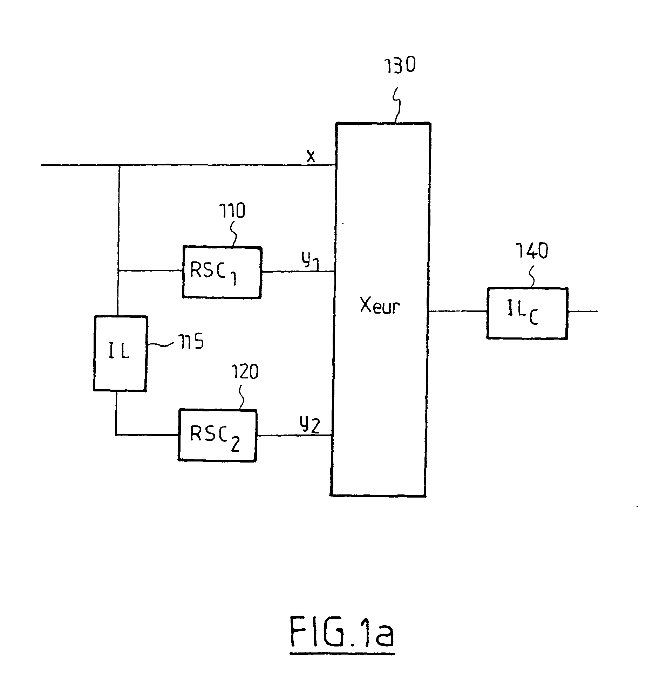

La Fig. 1a illustre de manière schématique un exemple de turbo-codeur. Le turbo-codeur représenté est un turbo-codeur parallèle de dimension 2. L'information x, sous la forme d'un bloc de données, est codée par un premier codeur élémentaire 110 pour fournir un première sortie $y_1$ et par un second codeur élémentaire 120, après avoir été entrelacée par l'entrelaceur 115, pour fournir une seconde sortie $y_2$. L'information systématique est multiplexée en 130 avec les informations codées $y_1$ et $y_2$ avant d'être entrelacée par un entrelaceur canal 140.

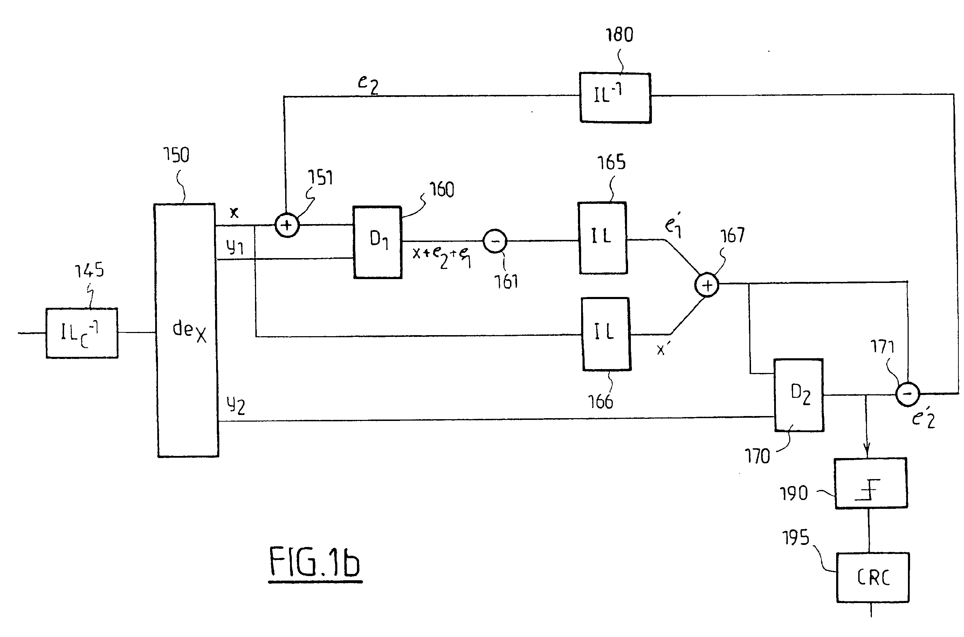

A la réception, l'information est décodée au moyen du turbo-décodeur représenté en Fig. 1b. Après désentrelacement dans le désentrelaceur canal 145, les informations x, $y_1$ et $y_2$ sont démultiplexées par le démultiplexeur 150. Les décodeurs élémentaires 160 et 170, par exemple du type Log MAP, correspondent respectivement aux codeurs élémentaires 110 et 120. Le décodeur 160, du type à entrée et à sortie pondérées, reçoit une information a priori sur x et l'information codée $y_1$ pour en déduire une information a posteriori sur x. La différence entre l'information a posteriori et l'information a priori est appelée information extrinsèque. L'information à priori sur x ainsi que l'information extrinsèque $e_1$ fournie par le premier décodeur sont entrelacées puis sommées pour fournir au décodeur 170 une nouvelle information a priori sur x (plus précisément sur x', version entrelacée de x). Le décodeur 170 estime à partir de cette information a priori et de l'information codée $y_2$, une information a posteriori sur x'. L'information intrinsèque $e'_2$ en est déduite par différence dans 171 avant d'être désentrelacée dans le désentrelaceur 180 puis est sommée en 151 à l'information systématique pour fournir une nouvelle information a priori de x au décodeur 160. Les étapes de décodage sont alors répétées et, ce, pour un nombre prédéterminé d'itérations $n_{itérations}$. Les valeurs souples en sortie du décodeur 170 sont soumises à un organe de décision 190 pour fournir des valeurs dures. Un contrôle de correction d'erreurs 195 opérant sur la sortie de 190 permet de déterminer si le bloc décodé est dépourvu d'erreurs et, dans l'affirmative, d'interrompre les itérations sans avoir à attendre le nombre prédéterminé $n_{itérations}$. Alternativement, pour décider de l'arrêt des itérations, le turbo-décodeur peut utilisé au lieu d'un CRC un autre critère d'arrêt sur les valeurs pondérées, tel que celui exposé, par exemple, dans l'article de J. Haguenauer et al. intitulé "Iterative decoding of binary block and convolutional codes", IEEE Transactions on Information Theory, vol. 42, pp.429-445, publié en Mars 1996 ou dans l'article de M. Moher intitulé "Decoding via cross entropy minimization", in Proc. IEEE Globecom Conf., Houston, TX, pp.809-813, publié en Decembre 1993.

Le principe du décodage itératif a été transposé à l'égalisation par C. Douillard et al. dans un article intitulé « Itérative Correction of Intersymbol Interference: Turbo-equalization » publié dans European Trans. Telecomm., Vol. 6, N˚5, Sept./Oct., pages 507-511. Cette méthode d'égalisation itérative, encore appelée turbo-égalisation part du principe qu'un canal affecté d'interférence inter-symbole (ISI) peut être considéré comme équivalent à un codeur convolutif et par conséquent la concaténation d'un codeur canal, d'un entrelaceur et d'un canal de transmission peut être elle même considérée comme l'équivalent d'un turbo-codeur.

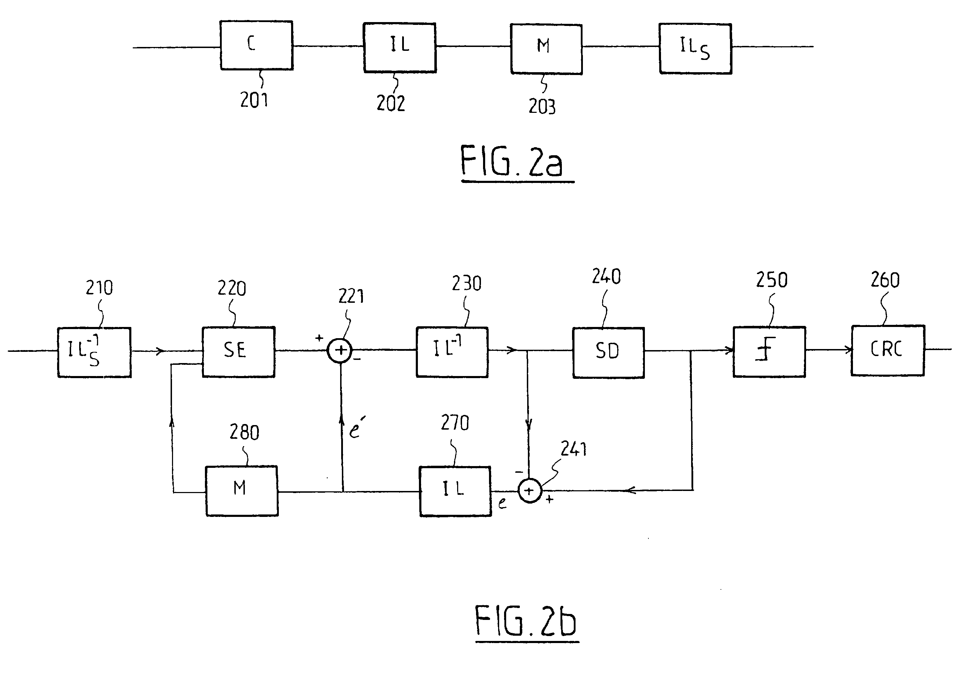

La Fig. 2b illustre de manière schématique la structure d'un turbo-égaliseur. On supposera que les données ont, du côté de l'émetteur représenté en Fig. 2a fait l'objet d'un codage canal dans un codeur 201 avant d'être entrelacées dans un entrelaceur 202 et modulées par un modulateur M-aire à symbole 203. Les données sont transmises sous la forme d'un bloc de symboles entrelacés par l'entrelaceur canal 204. Le turbo-égaliseur comprend tout d'abord un désentrelaceur canal 210 suivi d'un égaliseur à sortie pondérée de type Log-MAP fournissant des valeurs souples de données codées. Ces données sont désentrelacées dans le désentrelaceur 230 avant d'être décodées par un décodeur 240 de type Log-MAP à sortie pondérée. Les valeurs souples issues du décodeur 240 sont soumises à un organe de décision 250 fournissant les valeurs dures correspondantes. Les valeurs pondérées en entrée du décodeur 240 sont soustraites à celles de sortie pour fournir une information extrinsèque e. Après entrelacement, l'information extrinsèque est d'une part soustraite à la sortie de l'égaliseur 220 et d'autre part remodulée avant d'être transmise à l'égaliseur. A partir des symboles reçus et de l'information extrinsèque remodulée, l'égaliseur 220 procède à une nouvelle estimation a priori. Le turbo-égaliseur procède ainsi à un nombre prédéterminé d'itérations sur un bloc de symboles. Un contrôle de correction d'erreurs 260 en sortie de 250 diagnostique la présence ou l'absence d'erreurs, le processus d'itération est interrompu sans les itérations sans avoir à attendre le nombre prédéterminé $n_{itérations}$. Le critère d'arrêt peut alternativement porter sur les valeurs pondérées comme on l'a vu plus haut.

Notons sur le plan de la réalisation qu'aussi bien pour le turbo-codage que pour la turbo-égalisation, les itérations peuvent être effectuées l'une après l'autre au sein d'un même processeur ou dans des circuits dédiés arrangés en pipeline, chacun prenant en charge une itération de rang déterminé.

Dans le cas du turbo-codage comme celui de la turbo-égalisation, les performances en terme de taux d'erreurs binaires (TEB) ou de taux d'erreurs paquets (TEP) sont d'autant meilleures que la longueur de la taille $N$ de l'entrelaceur interne (IL) est grande. En effet, l'augmentation de la taille de l'entrelaceur interne, c'est-à-dire de la taille du bloc sur lequel est effectué l'entrelacement, améliore à la fois la distribution de poids de Hamming du turbo-code et l'efficacité du décodage itératif. Le gain d'entrelacement varie selon le type de turbo-code. On désignera par la suite sous le terme de «performances» indifféremment le TEB ou le TEP sur les données décodées.

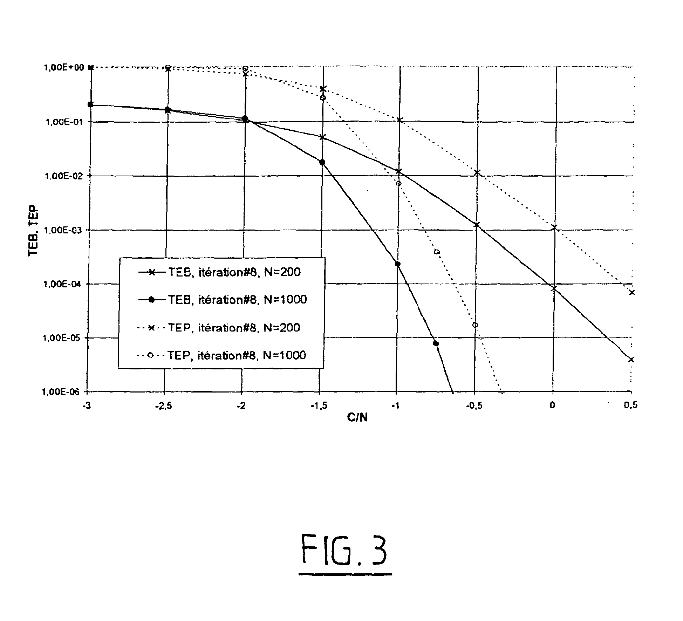

La Fig. 3 montre, à titre d'exemple, le gain d'entrelacement pour le turbo-codeur de la Fig. 1a, dont les codeurs élémentaires sont des codeurs RSC (Recursive Systematic Convolutional) de polynômes $(13,15)_{oct}$, lorsque la taille $N$ du bloc passe de 200 à 1000.

Lorsque le rapport signal à bruit (SNR ou C/N pour Carrier/Noise) est faible, il est connu de l'état de la technique d'utiliser des valeurs élevées de $N$ pour améliorer les performances du système. Cependant, l'augmentation de $N$ se fait au détriment de la latence du récepteur, c'est-à-dire du temps au bout duquel un bloc de données ou de symboles reçus est effectivement disponible sous forme décodée. En effet, le temps de latence au niveau du récepteur peut s'écrire :

$$T_{latence} = T_{rec} + \frac{N}{D_d} . n_{itérations} \tag{1}$$

où $D_d$ est le débit de décodage par itération et $T_{rec}$ est le temps au bout duquel le bloc de taille $N$ est disponible sous forme désentrelacée, au niveau du récepteur. Si un entrelacement canal de taille $M$, avec $M \geq N$, est appliqué au niveau de l'émetteur, on aura $T_{rec} = M/D_u$ où $D_u$ est le débit d'information utile. Si aucun entrelacement canal n'est utilisé, le temps de réception vaudra simplement $T_{rec} = N/D_u$.

Pour un temps de latence maximal donné ou temps de latence de consigne et un nombre prédéterminé d'itérations, la formule (1) permet d'obtenir la taille de bloc donnant les performances maximales.

A l'inverse, une diminution du temps de latence peut être obtenue en réduisant la taille des blocs, au prix toutefois d'une diminution corrélative des performances du système. Pour retrouver des performances acceptables, il est connu d'augmenter la puissance d'émission, ce qui grève bien entendu les ressources du système.

En outre, le document WO 99/50963 décrit un procédé de segmentation de blocs de données destinés à un turbo codage et décodage, dans lequel des blocs de données sont subdivisés en sous-blocs de taille égale choisie suffisamment grande pour assurer un taux d'erreurs acceptable mais suffisamment petite pour ne pas imposer un délai de transmission trop élevé ou une complexité du décodeur trop importante en terme de capacité mémoire.

Le problème à la base de l'invention est de déterminer, pour un temps de latence maximal donné et de manière générale pour des ressources données, une taille $N$ de bloc permettant de meilleures performances que celles de l'état de la technique.

La solution apportée par l'invention est définie par un procédé d'optimisation de taille de blocs de données codées, destinés à être soumis à un décodage itératif, comprenant une première étape évaluant une ressource disponible pour le décodage d'un bloc de taille courante et une seconde étape recherchant parmi une pluralité de tailles de bloc sous-multiples de la taille courante d'un facteur entier supérieur ou égal à 1 et nécessitant en moyenne un nombre d'itérations compatible avec ladite ressource disponible, celle qui permet d'obtenir le plus faible taux d'erreurs en sortie du décodage itératif.

La ressource disponible est par exemple un temps ou une énergie disponible pour recevoir toutes les données d'un bloc et pour effectuer le décodage itératif sur ledit bloc. Si les données ayant été entrelacées par un entrelaceur canal, ladite ressource disponible pourra être un temps ou une énergie disponible pour obtenir les données d'un bloc sous forme désentrelacée et pour effectuer le décodage itératif sur un bloc de données désentrelacées.

Avantageusement, la première étape détermine en outre pour la taille courante de bloc, le nombre maximal d'itérations compatible avec ladite ressource disponible. On estime alors, en fonction d'un taux d'erreurs maximal désiré, le nombre minimal d'itérations que doit effectuer le décodage itératif, pour la taille de bloc courante et le rapport signal à bruit.

La seconde étape pourra ne pas être effectuée si ledit nombre maximal d'itérations excède ledit nombre minimal d'itérations.

Selon un mode de réalisation, la seconde étape sélectionne parmi les tailles de blocs sous-multiples de la taille courante et parmi différents nombres maximaux d'itérations, la taille de bloc et le plus grand nombre maximal d'itérations associé à cette taille, donnant un nombre moyen d'itérations compatible avec ladite ressource disponible, on recherche parmi les tailles sous-multiples sélectionnées et pour les nombres maximaux d'itérations associés, la taille optimale qui permet d'obtenir le plus faible taux d'erreurs en sortie du décodage itératif.

Pour une taille sous-multiple d'un facteur $k$ donné et un nombre maximal d'itérations donné, le nombre moyen d'itérations pourra être déterminé en fonction du rapport signal à bruit comme la valeur moyenne du nombre d'itérations qu'effectuerait le décodage itératif pour chaque bloc d'une succession de blocs de taille sous-multiple, les itérations étant arrêtées sur un bloc de ladite taille sous-multiple si un critère de fiabilité prédéterminé est satisfait ou si le nombre d'itérations pour ce bloc atteint ledit nombre maximal d'itérations donné.

Avantageusement, les nombres moyens d'itérations pour différentes tailles sous-multiples, différents nombres maximaux d'itérations et différents rapports signal à bruit sont stockées dans une table. La table pourra être mise à jour au fur et à mesure du décodage itératif. Le cas échéant, les nombres moyens d'itérations seront obtenus par interpolation à partir des valeurs disponibles dans la table.

Selon une première variante, après que les données d'un bloc de taille initiale ont été codées comme une séquence de sous-blocs de taille optimale, les sous-blocs sont décodés, un par un, par une successions d'itérations du décodage itératif, les itérations étant arrêtées pour un sous-bloc si un critère de fiabilité prédéterminé est satisfait ou si le nombre d'itérations atteint le nombre maximal d'itérations associé à ladite taille optimale.

Selon une seconde variante, après que les données d'un bloc de taille initiale ont été codées comme une séquence de sous-blocs de taille optimale, les sous-blocs sont décodés en effectuant successivement sur chaque sous-bloc une itération du décodage itératif, une itération n'étant pas effectuée pour un sous-bloc si un critère d'arrêt prédéterminé est satisfait ou si le nombre d'itérations atteint le nombre maximal d'itérations associé à ladite taille optimale. Alternativement, une itération ne sera pas effectuée pour un sous-bloc si un critère d'arrêt prédéterminé est satisfait ou si ladite ressource disponible est épuisée.

L'invention est également définie par un dispositif de décodage itératif de blocs de données codées par un turbo-codeur comportant des moyens pour mettre en oeuvre le procédé d'optimisation exposé ci-dessus, lesdits moyens fournissant une taille de bloc optimale et le dispositif comprenant en outre des moyens pour transmettre au turbo-codeur une information de taille de bloc optimale.

L'invention concerne également un système de codage/décodage comprenant un turbo-codeur adapté à coder des blocs de données et un dispositif de décodage itératif comme défini ci-dessus, adapté à décoder les blocs de données codées par le turbo-codeur, ce dernier comprenant des moyens pour recevoir ladite information de taille de bloc optimale et pour modifier la taille d'au moins un entrelaceur interne en fonction de ladite information reçue.

L'invention concerne encore un dispositif de codage de bloc de données, le dispositif comportant des moyens pour mettre en oeuvre le procédé d'optimisation tel que défini ci-dessus, lesdits moyens fournissant une taille de bloc optimale, le dispositif comprenant en outre des moyens pour modifier adaptativement la taille des blocs de données codées en fonction de ladite taille de bloc optimale.

L'invention concerne enfin un dispositif de turbo-égalisation de blocs de données codées par un codeur et modulées, le dispositif comportant des moyens pour mettre en oeuvre le procédé d'optimisation défini plus haut, lesdits moyens fournissant une taille de bloc optimale, le dispositif comprenant en outre des moyens pour transmettre au codeur une information de taille de bloc optimale.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

la Fig. 1a illustre schématiquement un exemple de turbo-codeur connu de l'état de la technique ;

la Fig. 1b illustre schématiquement un exemple de turbo-décodeur, de structure connue, adapté à décoder des données codées par le turbo-codeur de la Fig. 1a ;

la Fig. 2a illustre schématiquement un exemple d'émetteur connu de l'état de la technique ;

la Fig. 2b illustre schématiquement un exemple de turbo-égaliseur connu de l'état de la technique ;

la Fig. 3 représente le gain d'entrelacement du turbo-codeur de la Fig. 1a en passant d'une première taille de bloc à une seconde taille de bloc ;

la Fig. 4a représente le nombre moyen d'itérations du turbo-décodeur de la Fig. 1b pour un nombre maximal d'itérations donné et lorsqu'un critère d'arrêt parfait est utilisé et dans le cas où la taille de bloc a une première valeur;

la Fig. 4b représente le nombre moyen d'itérations du turbo-décodeur de la Fig. 1b pour un nombre maximal d'itérations donné et lorsqu'un critère d'arrêt parfait est utilisé et dans le cas où la taille de bloc a une seconde valeur;

la Fig. 5 représente un histogramme du nombre d'itérations nécessaires pour satisfaire à un critère d'arrêt parfait ;

la Fig. 6 illustre l'avantage du moyennage du nombre d'itérations résultant de la présente invention ;

la Fig. 7 illustre les performances de turbo-codes de longueurs d'entrelacement et de nombres d'itérations de consigne différents ;

la Fig. 8 représente un organigramme de la méthode de détermination de la taille de bloc optimal selon un premier mode de réalisation de l'invention .

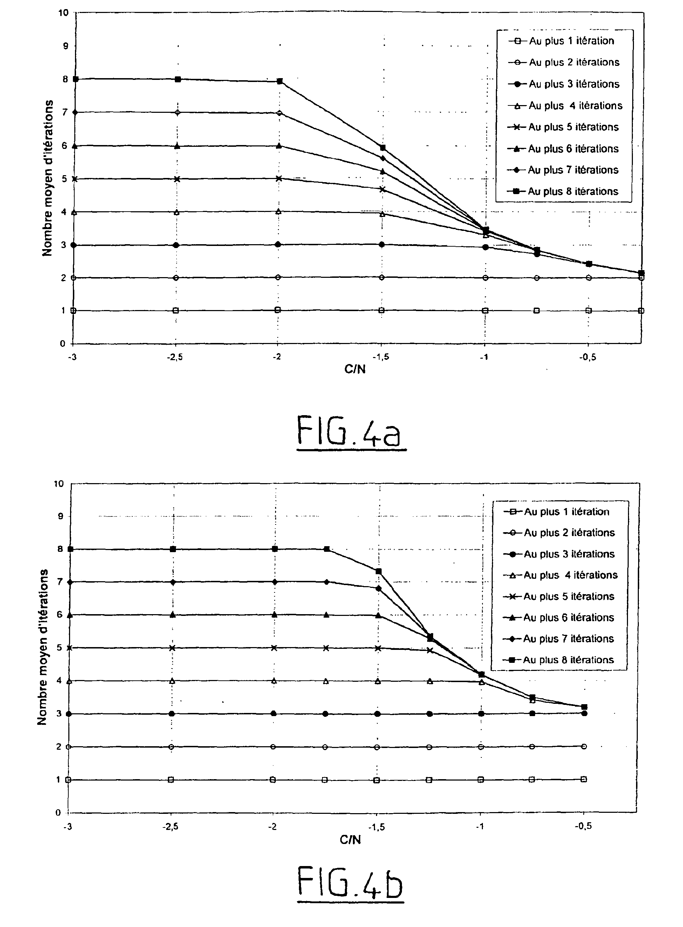

L'idée générale à la base de l'invention est de mettre à profit le fait que, dans un décodeur itératif, pour un nombre maximal d'itérations $n_{itérations}$ prédéterminé, que nous appellerons encore nombre de consigne, le bloc peut être entièrement décodé avant la dernière itération prévue. Par exemple, si le critère d'arrêt des itérations est un critère idéal parfait (TEB nul, c'est à dire absence complète d'erreurs dans le bloc), le nombre moyen d'itérations, $\overline{n}_{itérations}$, est souvent inférieur au nombre de consigne, comme on peut s'en rendre compte sur la Fig. 4a. Cette figure représente l'évolution de $\overline{n}_{itérations}$ en fonction du rapport signal à bruit pour différentes valeurs de $n_{itérations}$ et pour une taille de bloc de $N$=1000. La Fig. 4b représente cette évolution pour une taille de bloc $N$=10000. Dans les deux exemples, on voit que, pour un nombre maximal d'itérations donné, $n_{itérations}$ , le nombre moyen d'itérations n'atteint pas le maximum et, ce, d'autant que le rapport signal à bruit est élevé. Bien entendu, en pratique, on ne dispose pas de critère parfait : on teste l'absence d'erreurs par exemple au moyen d'un CRC et l'on arrête les itérations dès que le CRC ne détecte plus d'erreurs. Les conclusions concernant l'évolution de $\overline{n}_{itérations}$ par rapport à $n_{itérations}$ restent cependant valables.

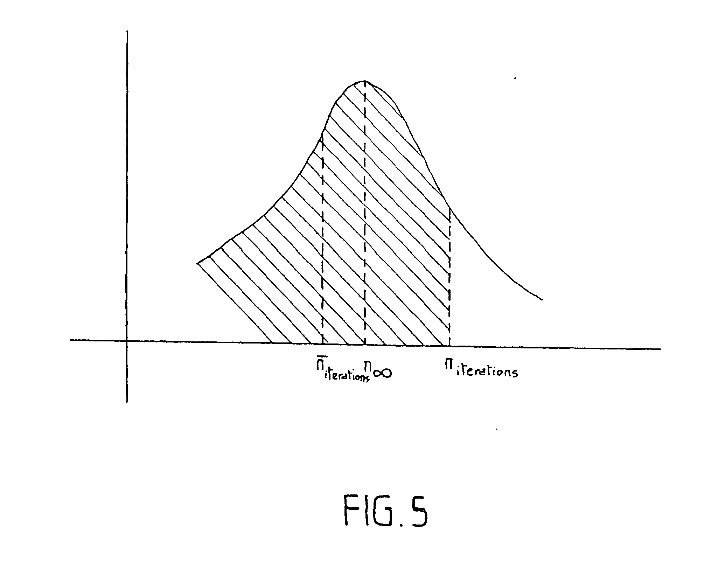

On a représenté schématiquement en Fig. 5 un histogramme du nombre d'itérations nécessaires à l'obtention d'un TEB (et donc d'un TEP) nul. Comme, en pratique, on ne peut effectuer un nombre infini d'itérations, l'on fixe, ainsi qu'on l'a vu plus haut, un nombre d'itérations de consigne $n_{itérations}$ compatible avec le temps de latence et on en déduit la taille de l'entrelaceur selon (1). La moyenne $\overline{n}_{\infty}$ de l'histogramme correspond à un nombre de consigne infini. Pour un nombre de consigne $n_{itérations}$ donné, la moyenne $\overline{n}_{itérations}$ est prise sur la zone hachurée de la courbe.

Supposons donné un temps de latence de consigne $T$ et que l'on ait déterminé un couple de valeurs ($n_{itérations}$, $N$) satisfaisant à $T_{latence} \leq T$ où $T_{latence}$ est donné par (1). Nous noterons par la suite $n_{itérations}$ et $T_{latence}$ respectivement $n_{itérations}^{(1)}$ et $T_{latence}^{(1)}$ .

Supposons maintenant que la taille $N$ du bloc, et donc celle de l'entrelaceur interne du turbo-codeur ou du turbo-égaliseur, soit divisée par un entier $k$ non nul. Le temps de latence $T_{latence}^{(k)}$ au bout duquel les $k$ blocs de taille réduite $N/k$ sont décodés s'exprime alors comme :

$$T_{latence}^{(k)}=T_{rec}^{(k)}+\sum_{i=1}^{k}\frac{N/k}{D_d}.n_{itérations}(i)=T_{rec}^{(k)}+\frac{N}{D_d}.\overline{n}_{itérations}^{(k)} \qquad (2)$$

où $T_{rec}^{(k)}$ est un temps de réception au bout duquel les $k$ blocs de taille $N/k$ sont disponibles, le cas échéant sous forme désentrelacée, au niveau du récepteur. En absence d'entrelacement canal, ce temps de réception vaut $\dfrac{N}{k.D_u}+\sum_{i=2}^{k}\delta t_{rec}^{(i)}$

où $\dfrac{N}{k.D_u}$ est le temps de réception du 1er bloc de taille $N/k$ et $\delta t_{rec}^{(i)}$ est le temps que doit attendre le récepteur entre la fin du décodage du $(i-1)$ème bloc et la fin de la réception du $i$ème bloc. Par conséquent, on a : $\dfrac{N}{k.D_u} \leq T_{rec}^{(k)} < \dfrac{N}{D_u}$ . En revanche, lorsqu'un entrelacement canal de taille $M_k$ avec $M_k \geq N/k$ a été appliqué au niveau de l'émetteur on a:

$$T_{rec}^{(k)} = M_k / D_u + \sum_{i=2}^{N/M_k} \delta_{rec}^{(i)} \quad \text{où} \quad \delta_{rec}^{(i)} \text{ est le temps d'attente entre la fin du désentrelacement du (i-1)}^{\text{ème}} \text{ groupe de } k.M_k/$$

$N$ blocs et leur décodage d'une part et la fin de la réception du $i^{\text{ème}}$ groupe d'autre part. En pratique, on prendra $M_k = N$

et donc $T_{rec}^{(k)} = M_k / D_u$ .

$n_{\text{itérations}}(i)$ est le nombre d'itérations effectuées par le décodeur sur le $i^{\text{ème}}$ bloc de taille $N/k$ en utilisant un critère d'arrêt prédéterminé et pour un nombre d'itérations de consigne $n_{\text{itérations}}^{(k)}$ donné ;

$\overline{n}_{\text{itérations}}^{(k)}$ est le nombre moyen d'itérations, pris sur l'ensemble des $k$ blocs. On notera que $\overline{n}_{\text{itérations}}^{(k)}$ dépend en général du nombre de consigne $n_{\text{itérations}}^{(k)}$ choisi pour la taille de bloc $N/k$ ainsi que du rapport signal à bruit. On désignera par la suite $(N/k, n_{\text{itérations}}^{(k)})$ un turbo-code opérant sur des blocs de taille $N/k$ et décodé au moyen d'au plus $n_{\text{itérations}}^{(k)}$ par bloc.

On notera d'abord qu'en général, la taille $M_k$ de l'entrelacement canal décroît (au sens large) avec $k$, et donc que $T_{rec}^{(k)}$ est une fonction décroissante de $k$ : $T_{rec}^{(k+1)} \leq T_{rec}^{(k)}$ qu'un entrelacement canal soit appliqué ou non.

On notera encore que le critère d'arrêt peut tolérer un taux d'erreurs résiduelles prédéterminé. On peut faire appel, comme évoqué plus haut, à un critère d'arrêt opérant sur (des) sortie(s) pondérée(s) ou une (des) information (s) extrinsèque(s) et déclencher l'arrêt des itérations lorsqu'un seuil de fiabilité prédéterminé est atteint. Dans tous les cas, le critère d'arrêt porte sur la fiabilité des blocs de données décodées et sera pour cette raison également nommé critère de fiabilité. Le critère d'arrêt utilisé est choisi identique pour toutes les valeurs de $k$.

L'invention repose sur le fait qu'il est généralement possible de trouver un entier $k$ et un nombre de consigne

$n_{\text{itérations}}^{(k)}$ tels que la contrainte $T_{\text{latence}}^{(k)} \leq T$ soit satisfaite tout en donnant de meilleures performances que pour $k=1$. La

relation $T_{\text{latence}}^{(k)} \leq T$ est généralement moins contraignante que $T_{\text{latence}}^{(1)} \leq T$ car elle fait intervenir le nombre moyen d'itérations $(\overline{n}_{\text{itérations}}^{(k)})$ et non le nombre maximal d'itérations $(n_{\text{itérations}}^{(1)})$.

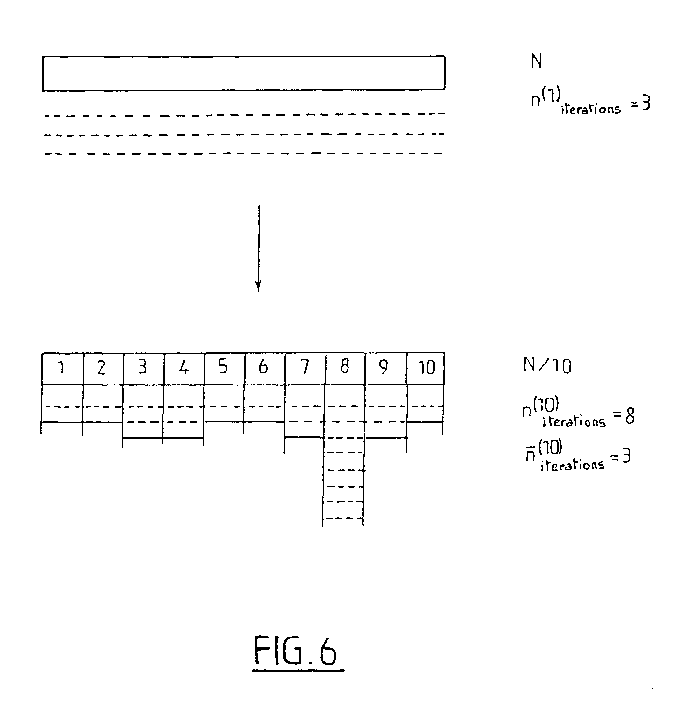

La comparaison entre les deux situations est illustrée en Fig. 6. Une itération est représentée par un trait horizontal s'étendant sur la longueur du bloc. Le trait est en pointillés s'il reste des erreurs après l'itération et en trait plein dans le cas contraire. La partie haute de la figure illustre le processus de décodage itératif sur un bloc de taille $N$

et pour un nombre de consigne $n_{\text{itérations}}^{(1)} = 3$ d'itérations, vérifiant la contrainte de latence $3N/D_d \leq T$ (on suppose pour simplifier qu'il n'y a pas d'entrelacement de canal et que le temps de réception est nul). Le processus itératif n'a pas convergé au bout de la $3^{\text{ième}}$ itération et le bloc décodé présente des erreurs résiduelles. La partie basse de la figure illustre la situation lorsque la taille du bloc est divisé par 10. Le nombre de consigne $n_{\text{itérations}}^{(10)}$ a été choisi égal à 8. On voit que le pour la grande majorité des blocs, le processus itératif converge bien avant $n_{\text{itérations}}^{(10)}$ et même avant $n_{\text{itérations}}^{(1)}$

itérations: dans cet exemple, seul le bloc n°8 présente encore des erreurs au bout de la $8^{\text{ième}}$ itération. La contrainte de latence est bien respectée car $\overline{n}_{\text{itérations}}^{(10)} = 3$ . La division du bloc a permis, à latence et à ressources calculatoires constantes de « concentrer » les itérations sur les blocs critiques. Ainsi les performances du récepteur sont, avant division du bloc, celles d'un turbo code de longueur $N$ avec 3 itérations de décodage alors, qu'après division, ce sont celles d'un turbo-code de longueur $N/10$ après 8 itérations de décodage.

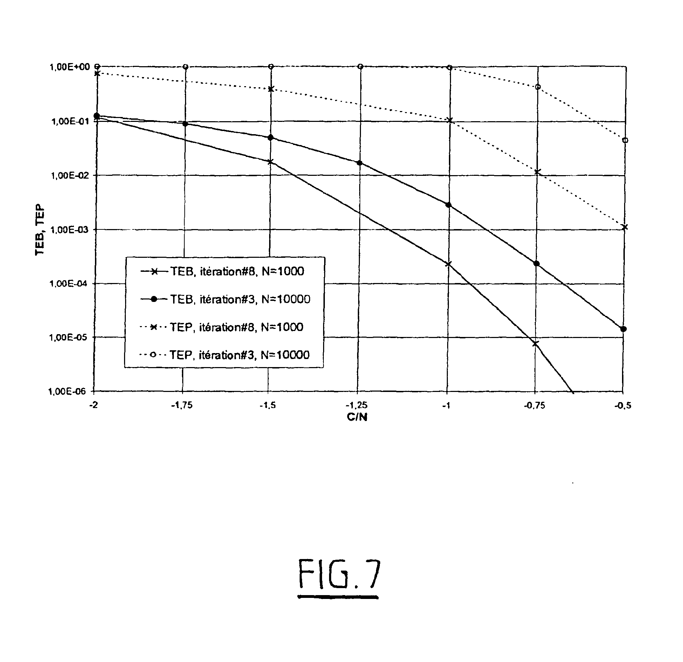

La Fig. 7 illustre les performances d'un turbo-code codé par le turbo-codeur de la Fig. 1a constitué de deux codeurs élémentaires de polynômes $(13,15)_{\text{oct}}$, lorsque la longueur du bloc (et donc de l'entrelaceur 115) passe de

$N=10000$ à $N=1000$ et lorsque le nombre d'itérations de consigne passe corrélativement de $n_{\text{itérations}}^{(1)} = 3$ à $n_{\text{itérations}}^{(10)} = 8$ .

Cette comparaison n'est valable que pour $\overline{n}_{\text{itérations}}^{(10)} \leq 3$ , ce qui correspond à C/N $\geq$-0.75dB comme on le voit sur la Fig.

4a. On constate en Fig. 4b que, pour un rapport signal à bruit de -0.75dB et $n_{\text{itérations}}^{(1)} = 3$ , le nombre moyen d'itérations

$\overline{n}_{\text{itérations}}^{(1)}$ est égal à la valeur maximale $n_{\text{itérations}}^{(1)}$ . Au contraire, dans les mêmes conditions, même rapport signal à bruit et $n_{itérations}^{(10)}=3$, on constate sur la Fig. 4a que le nombre moyen d'itérations $\overline{n}_{itérations}^{(10)}$ a décroché de sa valeur maximale. On peut augmenter $n_{itérations}^{(10)}$ tant que $\overline{n}_{itérations}^{(10)}$ reste inférieur à 3, ce qui est le cas jusqu'à $n_{itérations}^{(10)}=8$.

On observe sur la Fig. 7, pour la plage C/N≥-0.75dB ,qu'aussi bien en terme de TEB que de TEP la division de la taille de bloc par un facteur 10 apporte une amélioration sensible des performances du fait de l'augmentation du nombre maximal d'itérations à latence constante.

De manière générale, la division d'un bloc par un facteur $k$ permet de passer, à latence constante, d'un turbo-code de longueur $N$ associé à un nombre maximal d'itérations $n_{itérations}^{(1)}$ à un turbo-code ($N/k$, $n_{itérations}^{(k)}$) de longueur $N/k$ associé à un nombre maximal d'itérations $n_{itérations}^{(k)}$. Si, pour respecter la contrainte de latence, on a : $\overline{n}_{itérations}^{(k)}=n_{itérations}^{(1)}$, alors $n_{itérations}^{(k)}>n_{itérations}^{(1)}$, ce qui permet la concentration des itérations sur les blocs déficients.

Le choix du facteur $k$ est effectué en fonction des performances des turbo-codes ($N/k$, $n_{itérations}^{(k)}$) vérifiant $T_{latence}^{(k)}\leq T$. Le choix de $k$ est en fait un compromis entre le gain d'entrelacement, d'autant plus faible que $N/k$ est petit, et le gain dû au décodage itératif ($n_{itérations}^{(k)}>n_{itérations}^{(1)}$), d'autant plus élevé que $k$ est grand.

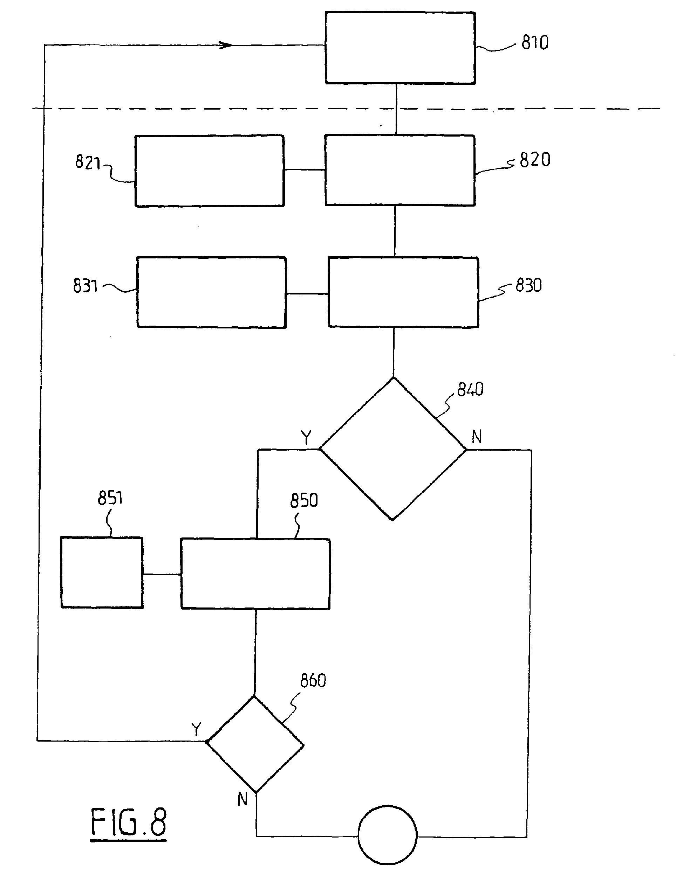

La Fig. 8 donne schématiquement un organigramme de la méthode d'optimisation de la taille de bloc selon un premier mode de réalisation de l'invention. L'émission représentée en 810 utilise une longueur d'entrelacement $N$. A la réception, on détermine en 820 à partir de $N$ ainsi que d'une estimation en 821 des ressources calculatoires et/ou du temps de latence maximal $T$, le nombre d'itérations de consigne $n_{itérations}^{(1)}$ grâce à l'équation (1). On détermine de même en 830, à partir de $N$ et du rapport signal à bruit C/N, à l'aide d'une table 831, le nombre d'itérations requis $n_{req}$ pour atteindre un niveau désiré de TEB ou de TEP. On compare ensuite, en 840, $n_{itérations}^{(1)}$ et $n_{req}$. Si $n_{itérations}^{(1)}\geq n_{req}$, on ne peut diviser la taille du bloc (car cela conduirait, à performances égales, à une augmentation du nombre d'itérations) et le processus d'optimisation est terminé. En revanche si $n_{itérations}^{(1)}<n_{req}$, on cherche en 850, dans une table 851, compte tenu du rapport signal à bruit, l'ensemble des couples ($N/k$, $n_{itérations}^{(k)}$), où $k\geq 1$ et diviseur de $N$, tels que $T_{latence}^{(k)}\leq T$. La valeur de $k$ donnant la meilleure performance (TEB,TEP) est alors sélectionnée, ainsi que le (plus grand) nombre maximal d'itérations $n_{itérations}^{(k)}$ associé permettant de vérifier $T_{latence}^{(k)}\leq T$. On teste en 860 si la valeur de $k$ sélectionnée est supérieure à une valeur seuil $k_{min}$ garantissant le moyennage des nombres d'itérations effectifs. Dans la négative, on ne procède pas à la division de la taille du bloc ($k=1$). En revanche, dans l'affirmative, le facteur $k$ est transmis au turbo-codeur sur une voie de retour. Le turbo-codeur adapte la taille des blocs à la valeur $N/k$ et la taille de son (ses) entrelaceur(s) interne(s) en conséquence.

Selon une variante de l'invention, on ne procède pas au test 840 et l'on recherche directement en 850 la valeur de $k$ et le nombre $n_{itérations}^{(k)}$ associé donnant la meilleure performance sous la contrainte de latence. On est ainsi assuré d'obtenir les meilleures performances possibles sous réserve du respect de ladite contrainte.

L'estimation des ressources en 821 peut être effectuée grâce à un algorithme de gestion de ressources dédié, ou bien, a posteriori, en examinant le nombre maximum d'itérations effectuées pour une taille de bloc $N/k$.

Les tables 831 et 851 peuvent être élaborées au préalable ou bien a posteriori à partir des performances obtenues et des nombres d'itérations effectifs. Elle peuvent également être élaborées au préalable et complétées au fur et à mesure de l'utilisation du système. Les valeurs indisponibles dans les tables peuvent être calculées par interpolation à partir des valeurs existantes.

Bien entendu, après division de la taille du bloc, le système peut ultérieurement retourner à une taille de bloc plus grande voire à la taille de bloc initiale si la contrainte de ressource (par exemple la contrainte de latence) est relaxée ou si la qualité de service (QoS) n'exige plus des performances optimales.

Selon un second mode de réalisation de l'invention, le processus d'optimisation de la taille du bloc est effectué à l'émission et le système ne comporte pas de voie de retour entre le récepteur et l'émetteur. L'algorithme ne dispose pas de l'estimation des ressources du récepteur, mais décide, pour un type d'application donné, d'améliorer le taux d'erreurs (TEB,TEP) sans augmenter le temps de latence du récepteur.

Lorsque la taille $N$ du bloc a été divisée par un facteur $k$, le processus itératif peut être effectué de deux manières possibles.

Selon une première variante, on effectue la 1ère itération de décodage pour chacun des $k$ blocs, puis on effectue

la 2ème itération de décodage pour les blocs présentant des erreurs résiduelles après la 1ère itération et ainsi de suite jusqu'à ce que le nombre maximal d'itérations soit atteint ou mieux jusqu'à ce que ladite ressource disponible ou le temps imparti pour le décodage des *k* blocs soit épuisé. A chaque passe on identifie grâce au critère d'arrêt les blocs présentant des erreurs résiduelles. De cette façon, on est sûr d'utiliser la ressource disponible ou la latence impartie de façon optimale et on évite de "s'attarder" trop longtemps sur le décodage d'un bloc, ce qui pourrait être préjudiciable aux blocs suivants si *k* n'est pas assez grand pour assurer un moyennage suffisant des itérations.

Dans le cas de l'exemple de la Fig. 6, la mise en oeuvre de cette variante se traduirait de la façon suivante :

1- Itération#1 pour les blocs 1 à 10
2- Itération#2 pour les blocs 1 à 10 -> blocs 1, 2, 5, 6, 10 corrects
3- Itération#3 pour les blocs 3, 4, 7, 8, 9 -> blocs 3, 4, 7, 9 corrects
4- Itération#4 pour le bloc 8
5- Itération#5 pour le bloc 8
6- Itération#6 pour le bloc 8
7- Itération#7 pour le bloc 8
8- Itération#8 pour le bloc 8

Cette première variante de décodage est avantageuse lorsque la durée d'entrelacement de canal $T_{ilc}$ est fixée ou lorsque *k* est petit. En effet, dans le premier cas, on doit attendre le temps $T_{ilc}$ avant de pouvoir décoder un bloc et, dans le second cas, elle permet de remédier au défaut éventuel de moyennage.

Selon une seconde variante, on décode successivement chacun des *k*=10 blocs. Au maximum $n_{it\acute{e}rations}^{(10)}=8$ itérations de décodage sont effectuées successivement sur chaque bloc en utilisant le critère d'arrêt pour atteindre idéalement $\overline{n}_{it\acute{e}rations}^{(10)}=3$ itérations par bloc en moyenne sur l'ensemble des *k* blocs.

Dans le cas de l'exemple de la Fig. 6, la mise en oeuvre de cette variante se traduirait de la façon suivante :

1. itérations #1 à #2 pour le bloc 1
2. itérations #1 à #2 pour le bloc 2
3. itérations #1 à #3 pour le bloc 3
4. itérations #1 à #3 pour le bloc 4
5. itérations #1 à #2 pour le bloc 5
6. itérations #1 à #2 pour le bloc 6
7. itérations #1 à #3 pour le bloc 7
8. itérations #1 à $n_{it\acute{e}rations}^{(10)}=8$ pour le bloc 8
9. itérations #1 à #3 pour le bloc 9
10. itérations # 1 à #2 pour le bloc 10

Cette deuxième variante est avantageuse lorsque la durée d'entrelacement de canal $T_{ilc}$ n'est pas fixée ou lorsque *k* est grand. En effet, si la durée $T_{ilc}$ n'est pas fixée, elle peut être réduite, éventuellement au prix d'une perte de performances, à une valeur correspondant à un entrelacement sur *k'*<*k* blocs de taille *k*/*N* consécutifs. Il en résulte que le temps de latence $T_{latence}^{(k)}$ donné par (2) peut être également réduit. Ce gain en temps de latence peut être converti en gain de performances en augmentant le nombre maximal d'itérations $n_{it\acute{e}rations}^{(k)}$ pour chacun des *k* blocs.

Il est essentiel de noter que la contrainte de latence dont il a été essentiellement question jusqu'ici n'est qu'un exemple de contrainte de ressource à respecter pour effectuer le décodage itératif. Par ressource, on pourra également entendre l'énergie dépensée par un processeur. Ce sera notamment le cas si le décodage itératif est pris en charge par un processeur rapide : la contrainte porte dans ce cas plus sur le nombre d'opérations à effectuer et donc sur l'énergie dépensée que sur le temps de calcul lui-même. De manière plus générale, on entendra par ressource une grandeur physique additive, ou une combinaison de telles grandeurs physiques, susceptible d'être dépensée par les moyens de calcul pour effectuer le décodage itératif.

En outre, bien que la description de l'invention ait été essentiellement illustrée comme un processus d'optimisation de taille de blocs turbo-codés sous contrainte de ressource, elle s'applique également, de manière similaire, à un processus d'optimisation de la taille de blocs turbo-égalisés sous contrainte de ressource, que cette optimisation soit effectuée au niveau du turbo-égaliseur (premier mode de réalisation) ou au niveau de l'émetteur (second mode de réalisation).

**EP 1 249 940 B1**

**Revendications**

1. Procédé d'optimisation de taille de blocs de données codées, destinés à être soumis à un décodage itératif, comprenant une première étape évaluant une ressource disponible ($T$) pour le décodage d'un bloc de taille courante ($N$) et une seconde étape recherchant parmi une pluralité de tailles ($N/k$) de bloc sous-multiples de la taille courante d'un facteur ($k$) entier supérieur ou égal à 1 et nécessitant en moyenne un nombre d'itérations ($\overline{n}_{itérations}^{(k)}$) compatible avec ladite ressource disponible, celle qui permet d'obtenir le plus faible taux d'erreurs en sortie du décodage itératif.

2. Procédé d'optimisation selon la revendication 1, **caractérisé en ce que** ladite ressource disponible est un temps ou une énergie disponible pour recevoir toutes les données d'un bloc et pour effectuer le décodage itératif sur ledit bloc.

3. Procédé d'optimisation selon la revendication 1, **caractérisé en ce que**, les données ayant été entrelacées par un entrelaceur canal, ladite ressource disponible est un temps ou une énergie disponible pour obtenir les données d'un bloc sous forme désentrelacée et pour effectuer le décodage itératif sur un bloc de données désentrelacées.

4. Procédé d'optimisation selon l'une des revendications 1 à 3, **caractérisé en ce que** la première étape détermine en outre pour la taille courante de bloc, le nombre maximal d'itérations ($n_{itérations}^{(1)}$) compatible avec ladite ressource disponible.

5. Procédé d'optimisation selon la revendication 4, **caractérisé en ce qu'**il comprend une étape d'estimation, en fonction d'un taux d'erreurs maximal désiré, du nombre minimal d'itérations ($n_{req}$) que doit effectuer le décodage itératif, pour la taille de bloc courante et le rapport signal à bruit.

6. Procédé d'optimisation selon la revendication 5, **caractérisé par** une étape de test et de branchement conditionnel à la seconde étape à la suite de laquelle la seconde étape n'est pas effectuée si ledit nombre maximal d'itérations excède ledit nombre minimal d'itérations.

7. Procédé d'optimisation selon l'une des revendications précédentes, **caractérisé en ce que** la seconde étape sélectionne parmi les tailles de blocs ($N/k$) sous-multiples de la taille courante et parmi différents nombres maximaux d'itérations, la taille de bloc et le plus grand nombre maximal d'itérations ($n_{itérations}^{(k)}$) associé à cette taille, donnant un nombre moyen d'itérations ($\overline{n}_{itérations}^{(k)}$) compatible avec ladite ressource disponible.

8. Procédé d'optimisation selon la revendication 7, **caractérisé en ce que** l'on recherche parmi les tailles sous-multiples sélectionnées et pour les nombres maximaux d'itérations associés, la taille optimale qui permet d'obtenir le plus faible taux d'erreurs en sortie du décodage itératif.

9. Procédé d'optimisation selon la revendication 7 ou 8, **caractérisé en ce que** pour une taille sous-multiple d'un facteur $k$ donné et un nombre maximal d'itérations donné, le nombre moyen d'itérations est déterminé en fonction du rapport signal à bruit comme la valeur moyenne du nombre d'itérations qu'effectuerait le décodage itératif pour chaque bloc d'une succession de blocs de taille sous-multiple, les itérations étant arrêtées sur un bloc de ladite taille sous-multiple si un critère de fiabilité prédéterminé est satisfait ou si le nombre d'itérations pour ce bloc atteint ledit nombre maximal d'itérations donné.

10. Procédé d'optimisation selon la revendication 9, **caractérisé en ce que** des nombres moyens d'itérations pour différentes tailles sous-multiples, différents nombres maximaux d'itérations et différents rapports signal à bruit sont stockées dans une table.

11. Procédé d'optimisation selon la revendication 10, **caractérisé en ce que** la table est mise à jour au fur et à mesure du décodage itératif.

12. Procédé d'optimisation selon la revendication 9 ou 10, **caractérisé en ce que** les nombres moyens d'itérations sont obtenus par interpolation à partir des valeurs disponibles dans la table.

**13.** Procédé de détermination de taille de bloc de données codées et de décodage itératif de blocs de données codées, les blocs ayant une taille initiale, **caractérisé par** une étape de détermination d'une taille optimale de bloc par le procédé selon une des revendications 7 à 12 et par une étape de décodage dans laquelle, les données d'un bloc de taille initiale ayant été codées comme une séquence de sous-blocs de taille optimale, les sous-blocs sont décodés, un par un, par une successions d'itérations du décodage itératif, les itérations étant arrêtées pour un sous-bloc si un critère de fiabilité prédéterminé est satisfait ou si le nombre d'itérations atteint le nombre maximal d'itérations associé à ladite taille optimale.

**14.** Procédé de détermination de taille de bloc de données codées et de décodage itératif de blocs de données codées, les blocs ayant une taille initiale, **caractérisé par** une étape de détermination d'une taille optimale de bloc par le procédé selon une des revendications 7 à 12 et par une étape de décodage dans laquelle, les données d'un bloc de taille initiale ayant été codées comme une séquence de sous-blocs de taille optimale, les sous-blocs sont décodés en effectuant successivement sur chaque sous-bloc une itération du décodage itératif, une itération n'étant pas effectuée pour un sous-bloc si un critère d'arrêt prédéterminé est satisfait ou si le nombre d'itérations atteint le nombre maximal d'itérations associé à ladite taille optimale.

**15.** Procédé de détermination de taille de bloc de données codées et de décodage itératif de blocs de données codées, les blocs ayant une taille initiale, **caractérisé par** une étape de détermination d'une taille optimale de bloc par le procédé selon une des revendications 7 à 12 et par une étape de décodage dans laquelle, les données un bloc de taille initiale ayant été codées comme une séquence de sous-blocs de taille optimale, les sous-blocs sont décodés en effectuant successivement sur chaque sous-bloc une itération du décodage itératif, une itération n'étant pas effectuée pour un sous-bloc si un critère d'arrêt prédéterminé est satisfait ou si ladite ressource disponible est épuisée.

**16.** Dispositif de détermination de taille de bloc de données codées et de décodage itératif de blocs de données codées par un turbo-codeur, **caractérisé en ce qu'**il comporte des moyens pour mettre en oeuvre le procédé d'optimisation selon l'une des revendications 1 à 12, lesdits moyens fournissant une taille de bloc optimale, le dispositif comprenant en outre des moyens pour transmettre au turbo-codeur une information de taille de bloc optimale.

**17.** Système de détermination de taille de bloc de données codées et de codage/décodage comprenant un turbo-codeur adapté à coder des blocs de données et un dispositif de détermination de taille de bloc de données codées et de décodage itératif selon la revendication 16 adapté à décoder les blocs de données codées par le turbo-codeur, ce dernier comprenant des moyens pour recevoir ladite information de taille de bloc optimale et pour modifier la taille d'au moins un entrelaceur interne en fonction de ladite information reçue.

**18.** Dispositif de détermination de taille de bloc de données codées et de codage de bloc de données, **caractérisé en ce qu'**il comporte des moyens pour mettre en oeuvre le procédé d'optimisation selon l'une des revendications 1 à 12, lesdits moyens fournissant une taille de bloc optimale, le dispositif comprenant en outre des moyens pour modifier adaptativement la taille des blocs de données codées en fonction de ladite taille de bloc optimale et des moyens de codage.

**19.** Dispositif de détermination de taille de bloc de données codées et de turbo-égalisation de blocs de données codées par un codeur et modulées, **caractérisé en ce qu'**il comporte des moyens pour mettre en oeuvre le procédé d'optimisation selon l'une des revendications 1 à 12, lesdits moyens fournissant une taille de bloc optimale, le dispositif comprenant en outre des moyens pour transmettre au codeur une information de taille de bloc optimale et des moyens de turbo-égalisation.

**Claims**

**1.** Method for optimising the size of coded data blocks which are intended to be subjected to iterative decoding, comprising a first step evaluating a resource ($T$) available for decoding a current block size ($N$) and a second step searching, amongst a plurality of block sizes ($N/k$) sub-multiple of the current size by an integer factor ($k$) which is greater than or equal to 1 and requiring on average a number of iterations $\left( \overline{n}_{iterations}^{(k)} \right)$ compatible with said available resource, for that which makes it possible to obtain the lowest output error rate of the iterative decoding.

**2.** Optimisation method according to claim 1, **characterised in that** said available resource is time or power available to receive all the data of a block and to effect iterative decoding on said block.

3. Optimisation method according to claim 1, **characterised in that**, the data having been interleaved by a channel interleaver, said available resource is time or power available to obtain the data of a block in de-interleaved form and to effect iterative decoding on a block of de-interleaved data.

4. Optimisation method according to one of the claims 1 to 3, **characterised in that** the first step determines furthermore for the current block size, the maximum number of iterations $\left( n^{(l)}_{iterations} \right)$ compatible with said available resource.

5. Optimisation method according to claim 4, **characterised in that** it comprises an estimation step, as a function of a desired maximum error rate, for the minimum number of iterations ($n_{req}$) which the iterative decoding must effect, for the current block size and the signal to noise ratio.

6. Optimisation method according to claim 5, **characterised by** a test and branching step which is conditional upon the second step subsequent to which the second step is not effected if said maximum number of iterations exceeds said minimum number of iterations.

7. Optimisation method according to one of the preceding claims, **characterised in that** the second step selects amongst the block sizes ($N/k$) sub-multiple of the current size and amongst various maximum numbers of iterations, the block size and the greatest maximum number of iterations $\left( n^{(k)}_{iterations} \right)$ associated with this size, giving an average number of iterations $\left( \overline{n}^{(k)}_{iterations} \right)$ compatible with said available resource.

8. Optimisation method according to claim 7, **characterised in that** there is sought, amongst the selected sub-multiple sizes and for the associated maximum numbers of iterations, the optimum size which makes it possible to obtain the lowest output error rate of the iterative decoding.

9. Optimisation method according to claim 7 or 8, **characterised in that**, for a size sub-multiple by a given factor $k$ and a given maximum number of iterations, the average number of iterations is determined as a function of the signal to noise ratio as the average value of the number of iterations which the iterative decoding would effect for each block of a succession of sub-multiple size blocks, the iterations being stopped on a block of said sub-multiple size if a predetermined reliability criterion is satisfied or if the number of iterations for this block reaches said given maximum number of iterations.

10. Optimisation method according to claim 9, **characterised in that** average numbers of iterations for various sub-mulitple sizes, various maximum numbers of iterations and various signal to noise ratios are stored in a table.

11. Optimisation method according to claim 10, **characterised in that** the table is updated during the iterative decoding.

12. Optimisation method according to claim 9 or 10, **characterised in that** the average numbers of iterations are obtained by interpolation from values available in the table.

13. Method for determining the size of a coded data block and for iterative decoding of coded data blocks, the blocks having an initial size, **characterised by** a step for determining an optimum block size by the method according to one of the claims 7 to 12 and by a decoding step in which the data of a block of an initial size having been coded as a sequence of optimum size sub-blocks, the sub-blocks are decoded, one by one, by a succession of iterations of the iterative decoding, the iterations being stopped for a sub-block if a predetermined reliability criterion is satisfied or if the number of iterations reaches the maximum number of iterations associated with said optimum size.

14. Method for determining the size of a coded data block and for iterative decoding of coded data blocks, the blocks having an initial size, **characterised by** a step for determining an optimum block size by the method according to one of the claims 7 to 12 and by a decoding step in which the data of a block of an initial size having been coded as a sequence of optimum size sub-blocks, the sub-blocks are decoded by successively effecting on each sub-block an iteration of the iterative decoding, an iteration not being effected for a sub-block if a predetermined stoppage criterion is satisfied or if the number of iterations reaches the maximum number of iterations associated with said

**EP 1 249 940 B1**

optimum size.

**15.** Method for determining the size of a coded data block and for iterative decoding of coded data blocks, the blocks having an initial size, **characterised by** a step for determining an optimum block size by the method according to one of the claims 7 to 12 and by a decoding step in which the data of a block of an initial size having been coded as a sequence of optimum size sub-blocks, the sub-blocks are decoded by successively effecting on each sub-block an iteration of the iterative decoding, an iteration not being effected for a sub-block if a predetermined stoppage criterion is satisfied or if said available resource is exhausted.

**16.** Device for determining the size of a coded data block and for iterative decoding of data blocks coded by a turbo coder, **characterised in that** it comprises means for implementing the optimisation method according to one of the claims 1 to 12, said means providing an optimum block size, the device comprising furthermore means for transmitting to the turbo coder information about the optimum block size.

**17.** System for determining the size of a coded data block and for coding/ decoding, comprising a turbo coder adapted to code data blocks and a device for determining the size of a coded data block and for iterative decoding according to claim 16, adapted to decode the data blocks coded by the turbo coder, the latter comprising means for receiving said information about the optimum block size and for modifying the size of at least one internal interleaver as a function of said received information.

**18.** Device for determining the size of a coded data block and for data block coding, **characterised in that** it comprises means for implementing the optimisation method according to one of the claims 1 to 12, said means providing an optimum block size, the device comprising furthermore means for modifying adaptatively the size of the coded data blocks as a function of said optimum block size and means for coding.

**19.** Device for determining the size of a coded data block and for turbo equalisation of data blocks coded by a coder and modulated, **characterised in that** it comprises means for implementing the optimisation method according to one of the claims 1 to 12, said means providing an optimum block size, the device comprising furthermore means for transmitting to the coder information about the optimum block size and means for turbo equalisation.

**Patentansprüche**

**1.** Verfahren zur Optimierung der Größe von codierten Datenblöcken, die dazu bestimmt sind, einer iterativen Decodierung unterzogen zu werden, umfassend einen ersten Schritt zum Berechnen einer verfügbaren Ressource (7) für die Decodierung eines Blocks der aktuellen Größe ($N$) und einen zweiten Schritt zum Suchen von derjenigen unter mehreren Blockgrößen ($N/k$), welche ganzzahlige Teile der aktuellen Blockgröße mit einem ganzzahligen Divisor ($k$) sind, der größer oder gleich 1 ist, und im Mittel eine Anzahl von Iterationen $\left( \overline{n}_{Iterationen}^{(k)} \right)$ erfordern, die mit der verfügbaren Ressource kompatibel ist, die es ermöglicht, am Ausgang der iterativen Decodierung die kleinste Fehlerrate zu erhalten.

**2.** Verfahren zur Optimierung nach Anspruch 1, **dadurch gekennzeichnet, dass** die verfügbare Ressource eine Zeit oder eine Energie ist, die verfügbar ist, um alle Daten eines Blocks zu empfangen und um die iterative Decodierung an dem Block durchzuführen.

**3.** Verfahren zur Optimierung nach Anspruch 1, **dadurch gekennzeichnet, dass** dann, wenn die Daten von einem Kanalverschachteler verschachtelt worden sind, die verfügbare Ressource eine Zeit oder eine Energie ist, die verfügbar ist, um die Daten eines Blocks in entschachtelter Form zu erhalten und um die iterative Decodierung an einem Block entschachtelter Daten durchzuführen.

**4.** Verfahren zur Optimierung nach einem der Ansprüche 1 bis 3, **dadurch gekennzeichnet, dass** im ersten Schritt außerdem für die aktuelle Blockgröße die maximale Anzahl von Iterationen $\left( n_{Iterationen}^{(1)} \right)$ bestimmt wird, die mit der verfügbaren Ressource kompatibel ist.

**5.** Verfahren zur Optimierung nach Anspruch 4, **dadurch gekennzeichnet, dass** es einen Schritt zum Schätzen der

**12**

minimalen Anzahl von Iterationen ($n_{erf}$), die bei der iterativen Decodierung für die aktuelle Blockgröße und das Signal/Rausch-Verhältnis ausgeführt werden müssen, in Abhängigkeit von einer gewünschten maximalen Fehlerrate umfasst.

6. Verfahren zur Optimierung nach Anspruch 5, **gekennzeichnet durch** einen Schritt zum Testen und zum bedingten Verzweigen zu dem zweiten Schritt, wonach der zweite Schritt nicht durchgeführt wird, wenn die maximale Anzahl von Iterationen die minimale Anzahl von Iterationen übersteigt.

7. Verfahren zur Optimierung nach einem der vorhergehenden Ansprüche, **dadurch gekennzeichnet, dass** im zweiten Schritt unter den Blockgrößen ($N/k$), die ganzzahlige Teile der aktuellen Blockgröße sind, und unter verschiedenen maximalen Anzahlen von Iterationen die Blockgröße und die mit dieser Blockgröße verknüpfte größte maximale Anzahl von Iterationen $\left( n_{Iterationen}^{(k)} \right)$ gewählt werden, die eine mittlere Anzahl von Iterationen $\left( \overline{n}_{Iterationen}^{(k)} \right)$ liefern, welche mit der verfügbaren Ressource kompatibel ist.

8. Verfahren zur Optimierung nach Anspruch 7, **dadurch gekennzeichnet, dass** unter den gewählten Blockgrößen, die ganzzahlige Teile sind, und für die zugehörigen maximalen Anzahlen von Iterationen die optimale Blockgröße gewählt wird, die es ermöglicht, am Ausgang der iterativen Decodierung die kleinste Fehlerrate zu erhalten.

9. Verfahren zur Optimierung nach Anspruch 7 oder 8, **dadurch gekennzeichnet, dass** für eine Blockgröße, die ein ganzzahliger Teil mit einem gegebenen Divisor $k$ ist, und eine vorgegebene maximale Anzahl von Iterationen die mittlere Anzahl von Iterationen in Abhängigkeit vom Signal/Rausch-Verhältnis als der Mittelwert der Anzahl von Iterationen bestimmt wird, welche bei der iterativen Decodierung für jeden Block einer Folge von Blöcken mit einer Größe, die ein ganzzahliger Teil ist, ausgeführt würden, wobei die Iterationen bei einem Block mit der Größe, die ein ganzzahliger Teil ist, abgebrochen werden, wenn ein vorgegebenes Zuverlässigkeitskriterium erfüllt ist oder wenn die Anzahl von Iterationen für diesen Block die vorgegebene maximale Anzahl von Iterationen erreicht.

10. Verfahren zur Optimierung nach Anspruch 9, **dadurch gekennzeichnet, dass** mittlere Anzahlen von Iterationen für verschiedene Blockgrößen, die ganzzahlige Teile sind, verschiedene maximale Anzahlen von Iterationen und verschiedene Signal/Rausch-Verhältnisse in einer Tabelle gespeichert werden.

11. Verfahren zur Optimierung nach Anspruch 10, **dadurch gekennzeichnet, dass** die Tabelle während der iterativen Decodierung nach und nach aktualisiert wird.

12. Verfahren zur Optimierung nach Anspruch 9 oder 10, **dadurch gekennzeichnet, dass** die mittleren Anzahlen von Iterationen ausgehend von den in der Tabelle verfügbaren Werten durch Interpolation erhalten werden.

13. Verfahren zur Bestimmung der Größe von codierten Datenblöcken und zur iterativen Decodierung von codierten Datenblöcken, wobei die Blöcke eine Anfangsgröße haben, **gekennzeichnet durch** einen Schritt zum Bestimmen einer optimalen Blockgröße mittels des Verfahrens nach einem der Ansprüche 7 bis 12 und **durch** einen Schritt zum Decodieren, in welchem dann, wenn die Daten eines Blocks mit der Anfangsgröße als eine Folge von Unterblöcken mit optimaler Größe codiert worden sind, die Unterblöcke einer nach dem anderen **durch** eine Folge von Iterationen der iterativen Decodierung decodiert werden, wobei die Iterationen für einen Unterblock abgebrochen werden, wenn ein vorgegebenes Zuverlässigkeitskriterium erfüllt ist oder wenn die Anzahl der Iterationen die maximale Anzahl von Iterationen erreicht, die mit der optimalen Größe verknüpft ist.

14. Verfahren zur Bestimmung der Größe von codierten Datenblöcken und zur iterativen Decodierung von codierten Datenblöcken, wobei die Blöcke eine Anfangsgröße haben, **gekennzeichnet durch** einen Schritt zum Bestimmen einer optimalen Blockgröße mittels des Verfahrens nach einem der Ansprüche 7 bis 12 und **durch** einen Schritt zum Decodieren, in welchem dann, wenn die Daten eines Blocks mit der Anfangsgröße als eine Folge von Unterblöcken mit optimaler Größe codiert worden sind, die Unterblöcke decodiert werden, indem nacheinander an jedem Unterblock eine Iteration der iterativen Decodierung durchgeführt wird, wobei eine iteration für einen Unterblock nicht durchgeführt wird, wenn ein vorgegebenes Abbruchkriterium erfüllt ist oder wenn die Anzahl der Iterationen die maximale Anzahl von Iterationen erreicht, die mit der optimalen Größe verknüpft ist.

15. Verfahren zur Bestimmung der Größe von codierten Datenblöcken und zur iterativen Decodierung von codierten Datenblöcken, wobei die Blöcke eine Anfangsgröße haben, **gekennzeichnet durch** einen Schritt zum Bestimmen einer optimalen Blockgröße mittels des Verfahrens nach einem der Ansprüche 7 bis 12 und **durch** einen Schritt zum Decodieren, in welchem dann, wenn die Daten eines Blocks mit der Anfangsgröße als eine Folge von Unterblöcken mit optimaler Größe codiert worden sind, die Unterblöcke decodiert werden, indem nacheinander an jedem Unterblock eine Iteration der iterativen Decodierung durchgeführt wird, wobei eine Iteration für einen Unterblock nicht durchgeführt wird, wenn ein vorgegebenes Abbruchkriterium erfüllt ist oder wenn die verfügbare Ressource erschöpft ist.

16. Vorrichtung zur Bestimmung der Größe von codierten Datenblöcken und zur iterativen Decodierung von codierten Datenblöcken durch einen Turbocodierer, **dadurch gekennzeichnet, dass** sie Mittel zum Durchführen des Verfahrens zur Optimierung nach einem der Ansprüche 1 bis 12 umfasst, wobei die Mittel eine optimale Blockgröße liefern, wobei die Vorrichtung außerdem Mittel zum Übertragen einer Information über die optimale Blockgröße zum Turbocodierer umfasst.

17. System zur Bestimmung der Größe von codierten Datenblöcken und zur Codierung/Decodierung, umfassend einen Turbocodierer, der in der Lage ist, Datenblöcke zu codieren, und eine Vorrichtung zur Bestimmung der Größe von codierten Datenblöcken und zur iterativen Decodierung nach Anspruch 16, die in der Lage ist, die von dem Turbocodierer codierten Datenblöcke zu decodieren, wobei der Letztere Mittel umfasst, um die Information über die optimale Blockgröße zu empfangen und um die Blockgröße mindestens eines internen Verschachtelers in Abhängigkeit von der empfangenen Information zu ändern.

18. Vorrichtung zur Bestimmung der Größe von codierten Datenblöcken und zur Codierung von Datenblöcken, **dadurch gekennzeichnet, dass** sie Mittel zur Durchführung des Verfahrens zur Optimierung nach einem der Ansprüche 1 bis 12 umfasst, wobei die Mittel eine optimale Blockgröße liefern, wobei die Vorrichtung außerdem Mittel zum adaptiven Ändern der Größe der codierten Datenblöcke in Abhängigkeit von der optimalen Blockgröße und Mittel zum Decodieren umfasst.

19. Vorrichtung zur Bestimmung der Größe von codierten Datenblöcken und zur Turbo-Entzerrung von Datenblöcken, die mittels eines Codierers codiert wurden und moduliert wurden, **dadurch gekennzeichnet, dass** sie Mittel zur Durchführung des Verfahrens zur Optimierung nach einem der Ansprüche 1 bis 12 umfasst, wobei die Mittel eine optimale Blockgröße liefern, wobei die Vorrichtung außerdem Mittel zur Übertragung einer Information über die optimale Blockgröße zum Codierer und Mittel zur Turbo-Entzerrung umfasst.

$$\underline{\text{FIG.1a}}$$

**FIG.1b**

EP 1 249 940 B1

C | 201

IL | 202

M | 203

IL$_S$

## FIG.2a

210 IL$_S^{-1}$

220 SE

221 $\oplus$ + −

230 IL$^{-1}$

240 SD

250

260 CRC

280 M

é´

270 IL

241 $\oplus$ − + $e$

## FIG.2b

FIG. 3

## FIG.4a

## FIG.4b

$\overline{n}_{iterations}$ $n_\infty$ $n_{iterations}$

FIG.5

N

$n^{(1)}_{iterations} = 3$

N/10

$n^{(10)}_{iterations} = 8$

$\bar{n}^{(10)}_{iterations} = 3$

# FIG.6

FIG.7

FIG.8